(19) Europäisches Patentamt
European Patent Office
Office européen des brevets

(11) **EP 1 545 007 B1**

## (12) EUROPEAN PATENT SPECIFICATION

(45) Date of publication and mention
of the grant of the patent:
**01.08.2007 Bulletin 2007/31**

(51) Int Cl.:
*H03L 7/081* (2006.01)  *H03D 3/00* (2006.01)
*H03B 27/00* (2006.01)

(21) Application number: **04447281.9**

(22) Date of filing: **17.12.2004**

(54) **Local oscillator for harmonic image-rejection mixers**

Lokaloszillator für einen harmonischen Mischer mit Unterdrückung der Spiegelfrequenz

Oscillateur local pour mixeur harmonique à réjection d'image

(84) Designated Contracting States:
**AT BE BG CH CY CZ DE DK EE ES FI FR GB GR HU IE IS IT LI LT LU MC NL PL PT RO SE SI SK TR**

(30) Priority: **19.12.2003 EP 03447297**

(43) Date of publication of application:
**22.06.2005 Bulletin 2005/25**

(73) Proprietors:
• **INTERUNIVERSITAIR MICROELEKTRONICA CENTRUM ( IMEC)**
**3001 Leuven (BE)**
• **STMicroelectronics Belgium N.V.**
**1930 Zaventem (BE)**

(72) Inventor: **Craninckx, Jan Frans Lucien**
**3370 Boutersem (BE)**

(74) Representative: **pronovem**
**Office Van Malderen**
**Ave. Josse Goffin 158**
**1082 Brussels (BE)**

(56) References cited:
**US-A- 5 146 121**    **US-A- 5 180 994**
**US-A- 5 285 120**    **US-A1- 2002 039 052**

• **YAMAJI T ET AL: "I/Q ACTIVE BALANCED HARMONIC MIXER WITH IM2 CANCELERS AND A 45° PHASE SHIFTER" IEEE JOURNAL OF SOLID-STATE CIRCUITS, IEEE INC. NEW YORK, US, vol. 33, no. 12, December 1998 (1998-12), pages 2240-2246, XP000880529 ISSN: 0018-9200**

## Description

### Field of the invention

The present invention is related to a device that generates signals to be used for frequency conversion in image-reject mixers.

### State of the art

To implement low-cost single-chip RF transceivers current receive and transmit architectures employ zero-IF or low-IF techniques. The image frequency is no longer suppressed by filtering as in the heterodyne architectures. In these architectures image-reject or quadrature up- and downconversion mixers are used. The main problem of these image-rejection transceivers is they rely on a local oscillator (LO) having an in-phase component (I) and a quadrature component (Q) spaced exactly 90° apart. The I and Q LO signals often lead to difficulties in practical implementations.

In state of the art solutions LO signals in quadrature can be generated by a 4-stage ring oscillator. Ring oscillators however produce too much phase noise to be used in most telecom applications. Alternatively, the LO signals (I and Q) generation can be performed starting from a normal VCO signal with an RC/CR circuit. The RC time constant should then equal the input signal period, which is never exactly the case in practice. Further the oscillator runs at the same frequency as the RF output signal, which makes the VCO susceptible to pulling by the power amplifier, causing unwanted spurs in the output signal.

Other solutions consist in applying a quadrature LC-oscillator, coupling two high-quality LC oscillators in such a way that their output signals are 90° apart. These two oscillators however take up a large area and they are also very susceptible to pulling.

Another alternative exists in using an oscillator running at the double frequency of the output signals. One can then obtain signals in quadrature with a simple divide-by-2 toggle flipflop. Running at twice the required operating frequency however, if even possible notwithstanding technological limitations, takes a lot of power. The pulling problem is not completely solved either, since the VCO can be pulled by the second harmonic of the power amplifier.

Patent document US-5285120-A discloses an electric circuit providing a constant phase shift between two output signals derived from a common input. The common input is applied both to a non-shift channel comprising a fixed attenuator and a phase shift channel comprising a low-pass RC circuit.

Document US 5180994-A relates to a ring oscillator with quadrature outputs. The fully differential four stage ring oscillator has outputs from alternate delay elements combined in balanced XOR gate frequency doublers to provide both in-phase and quadrature output signals at twice the ring oscillator frequency.

Patent application US2002/0039052-A1 discloses a quadrature oscillator with phase error correction. It comprises a local oscillator that generates a single-ended clock signal, which is subsequently converted into differential clock signal. From this differential clock signal an in-phase and quadrature carrier signal are then derived. The phase error between both carrier signals is measured and used for modifying the differential clock signal by means of a feedback amplifier.

### Aims of the invention

The present invention aims to provide a device facilitating the generation of an in phase and a quadrature component LO signal, thereby overcoming the problems of the state of the art solutions.

### Summary of the invention

The present invention relates to a device for generating (at least two) signals spaced $\pi/X$ rad apart, X being an integer, comprising

- at least one tunable delay cell with a delay approximately corresponding to a phase shift $\pi/X$ rad,
- at least one phase detection system inputting at least two signals delayed delayed by $\pi/2$ rad with respect to one another by the delay cells and generating a feedback signal to at least one delay cell.

In a preferred embodiment the combination of the delay cells and the phase detection system provides the $\pi/X$ rad spacing of the signals. In a specific embodiment X equals 4.

In an advantageous embodiment the phase detection system is a mixer.

Preferably the device further comprises a low pass filter for filtering the feedback signal.

In a specific embodiment the feedback signal is fed to all delay cells.

The invention also relates to a device comprising

- a device as described above, generating a plurality of signals at the first frequency, which is a subharmonic frequency of the second frequency, and whereby the at least two signals to be converted are selected from said plurality of signals, and
- first means for combining the at least two signals from the plurality of signals, yielding a first signal set containing at least one signal at the second frequency.

Preferably the at least two signals to be combined by said first means for combining are spaced $2\pi/X$ rad apart and the second frequency is $X/2$ times larger than the first frequency. Advantageously X equals 4.

In an even more preferred embodiment the device further comprises a second means for combining the at least two signals at said first frequency from said plurality of signals, yielding a second signal set containing at least one signal at said second frequency. Again, the at least two signals to be combined by the second means for combining are spaced $2\pi/X$ rad apart and the second frequency is $X/2$ times larger than the first frequency. For each of the at least two signals to be combined by the second means for combining there is a signal among the at least two signals to be combined by the first means for combining, that differs $\pi/X$ rad in phase. This results in said first and second signal set at said second frequency being spaced $\pi/2$ apart, which is preferable for the LO signals in image-reject up- or downconverters. Advantageously X is taken equal to 4.

Advantageously the means for combining signals includes a logic circuit or a combination of switches.

As another object the invention relates to a device for frequency multiplication comprising a local oscillator running at a subharmonic frequency of a transceived signal, generating at least one output signal. The device further comprises means for actively generating signals, spaced $\pi/2N$ rad apart, N being an integer. By 'actively' is meant that no passive components like resistors or capacitors are used. The local oscillator runs at the N-th subharmonic of said transceived signal. The at least one output signal is generated by said signals, spaced $\pi/2N$ rad apart. In a most preferred embodiment N = 2. Said means for actively generating signals advantageously exploits a feedback mechanism for keeping the signals spaced $\pi/2N$ rad apart. In a preferred embodiment the means for actively generating signals are a device for generating signals as previously described.

In a specific embodiment the device for frequency conversion generates an in-phase and a quadrature output signal.

In a further object the invention relates to a front-end device, comprising a device for frequency conversion as described above and a mixer to which the at least one output signal and said transceived signal are fed.

In yet a further object the invention relates to a zero or low-IF front end, comprising a frequency conversion device as described above and an image-reject mixer to which the in-phase and quadrature output signals and said transceived signal are fed.

In a more advanced embodiment the front end device comprising a frequency conversion device as described above, possesses some programmable parameters. The programmable parameters comprise the integer value N and the number of signals to be generated. The front end device may further comprise reconfigurable means for combining said generated signals.

## Short description of the drawings

Fig. 1 represents a direct upconversion transmitter.

Fig. 2 represents a RC/CR phase shifter.

Fig. 3 represents a harmonic image-rejection upconversion.

Fig. 4 represents a harmonic mixer example.

Fig. 5 represents an embodiment as frequency doubling device.

Fig. 6 represents some harmonic mixer waveforms.

Fig. 7 represents a delay-locked loop for half-frequency 8-phase LO signal generation.

## Detailed description of the invention

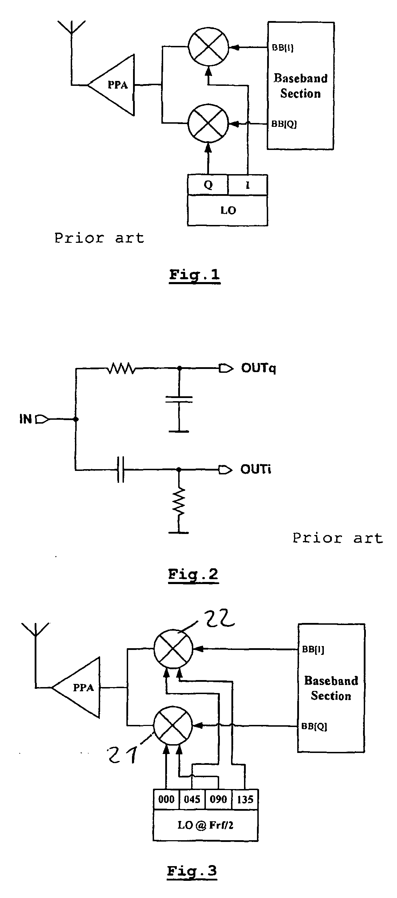

A prior art solution is shown in Fig. 1. The figure represents the basic schematic of a direct-upconversion (or zero-IF) transmitter. The baseband signals are defined as:

$$BB_I = \cos(\omega_{BB} \cdot t)$$

$$BB_Q = \sin(\omega_{BB} \cdot t)$$

The LO signals are defined as:

$$LO_I = \cos(\omega_{LO} \cdot t)$$

$$LO_Q = \sin(\omega_{LO} \cdot t)$$

The circuit in Figure 1 thus performs the following function:

$$
\begin{aligned}
RF &= BB_I \cdot LO_Q + BB_Q \cdot LO_I \\
&= \cos(\omega_{BB} \cdot t) \times \sin(\omega_{LO} \cdot t) + \sin(\omega_{BB} \cdot t) \times \cos(\omega_{LO} \cdot t) \\
&= \sin((\omega_{LO} + \omega_{BB}) \cdot t) \\
&= \sin(\omega_{RF} \cdot t)
\end{aligned}
$$

which is a perfect single-sideband mixer. A similar calculation can be performed for the receiver side.

The generation of LO signals in quadrature can also be done starting from a normal VCO signal (IN) with an RC/CR circuit as shown in Fig. 2. If the RC-time constant is equal to the frequency of the input signal, one path shifts the phase by +45° and the other path shifts by -45°, thus rendering two LO signals (OUTi and OUTq) 90° apart. The problems of an RC/CR phase shifter are twofold:

- First, due to process variations the RC time constant never exactly equals the input frequency. This does not influence the phase difference between the two outputs, but it does influence their amplitude. So if the mixers are susceptible to the amplitude of their LO signals, this will give imperfect image rejection. Extensions of the basic RC/CR phase shifter are polyphase networks, which use several sections at different frequencies in order to obtain a good image rejection over a wide band (at the expense of larger area and power).

- Second, the oscillator in the synthesiser is running at the same frequency as the RF output signal. This makes this VCO very susceptible to pulling by the power amplifier in TX mode, thus creating unwanted spurs in the output signal. In RX mode DC offsets are generated by coupling of the VCO signal to the RF input. These DC offsets are a major problem for implementing zero-IF receivers.

To solve both the problem of VCO pulling in transmit mode and DC offsets in receive mode, the VCO will be operated at a sub-harmonic of the RF signal and a harmonic mixer is used. The key element is the generation of LO signals in quadrature at this subharmonic frequency, which shouldn't be spaced $\pi/2$ rad apart, but $\pi/2N$ rad (wherein N denotes the subharmonic order, e.g. 2). A delay-locked loop generates these LO signals. Note that "spaced $y$ rad apart" means the signals have the same frequency, but they have a phase difference of $y$ rad.

The main goal of the proposed solution is to run the oscillator at a subharmonic (e.g. half) of the RF frequency, in order to avoid pulling. In that case the upconversion mixer must be a harmonic mixer. Also, in order to retain an image-rejection upconversion, 45° spaced LO signals are then needed. A possible solution for implementing a harmonic mixer applies a 45° phase shifter consisting of two RC-bridge circuits (see 'An I/Q Active Balanced Harmonic Mixer with IM2 Cancelers and a 45° phase Shifter', IEEE Journal of Solid-State Circuits, vol. 33, no. 12, Dec.1998, pp 2240-2246). In the invention a different approach is followed. In Fig. 3 two signals spaced $2.\pi/4$ rad apart are combined to yield either the I or the Q component at RF frequency: in one case signals with phase 0 and $\pi/2$ are taken together, in the other those with $\pi/4$ and $3\pi/4$. For each of the signals going to one mixer (21), there is a signal that differs $\pi/4$ rad in phase, going to the other mixer (22).

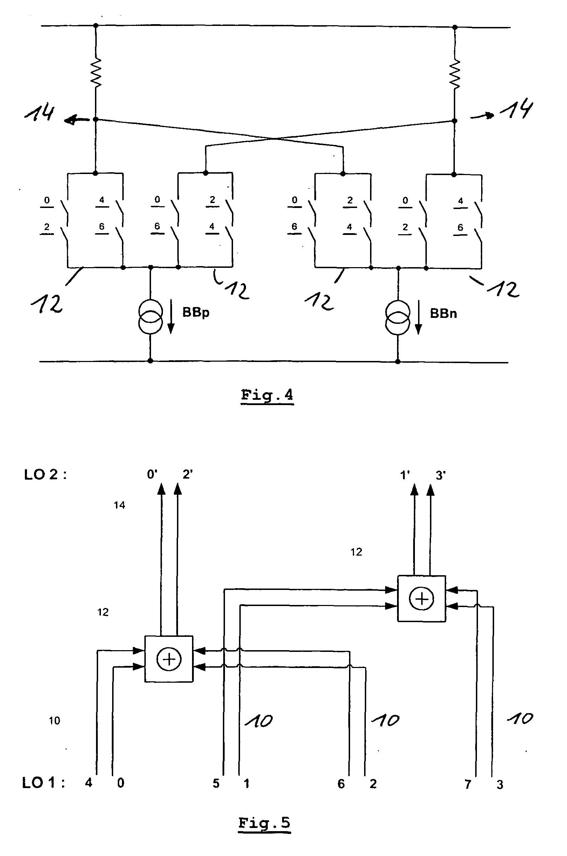

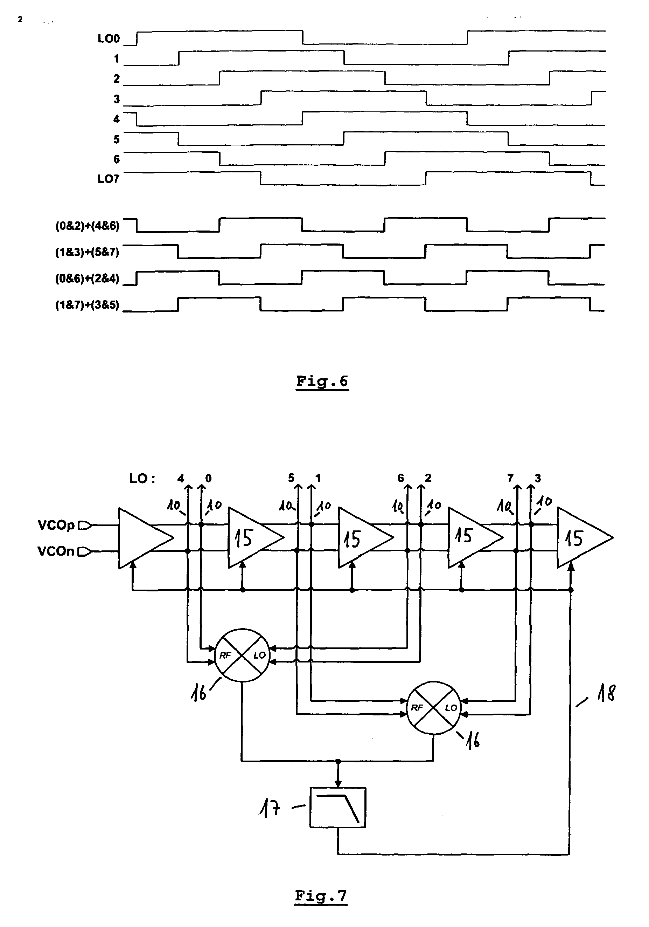

An example of a harmonic upconversion circuit is shown in Fig. 4 (only the I-mixer is shown). It looks similar to a standard Gilbert-cell mixer, except that the four switch transistors have been replaced by a new switch structure. The LO signals (10) have an index, which is proportional to their phase in units of 45°, so $LO_i = \cos(\omega_{LO} \cdot t + i.45°)$ with i=0,1,...,7. The waveforms of the LO signals (10) and their corresponding equivalent signal in the mixer are shown in Fig. 6. This circuit is equivalent to putting an XOR gate on the half-frequency LO signals (as shown in Fig. 5) before feeding them into a regular mixer. A similar circuit can be used for downconversion.

To create the 8 half-frequency LO signals (10) at 45° spacing, the circuit of Fig. 7 can be used. It consists of a series of voltage-controlled delay cells (15), the delay of which is tuned to 45° by a feedback loop similar to a PLL. Four delay cells with a delay approximately corresponding to $\pi/4$ rad are needed in this case. The mixers operate as phase detectors (16), but due to the implementation as Gilbert cells, their output is zero when the 'RF' and 'LO' signals are spaced 90° apart. To avoid deterministic phase mismatch, the phase detectors should be implemented symmetrically w.r.t. their RF and LO inputs. This basically means that preferably two mixers (21,22) of half the size must be used, with their inputs swapped.

As for phase noise on the 8-phase LO signals, this is determined almost completely by the oscillator signals. The delay cells (15) must be implemented such that their noise is negligible, and if the loop bandwidth is sufficiently small, this only contributes to close-by phase noise.

In a specific embodiment the invention relates to a frequency multiplication device. Fig.5 shows a device that converts the original LO signals to new LO signals at the actual RF frequency. The LO signals (10) shown in Fig. 7 are the inputs. The phase detector (16) in Fig. 7 can also be used with the signals of LO2.

It is evident that a similar circuit can be described operating on a frequency $\omega_{LO}$ equal to 1/3$^{rd}$ of the RF frequency, requiring 12 LO signals (10) spaced $2\pi/12$ rad = 30° apart. In this case LO signals (10) are generated $LO_i = \cos(\omega_{LO}\cdot t + i\cdot 30°)$, with i = 0,1,...,11 (or i = 0,1,...,5 in case no symmetrical implementation is chosen). Three signals must then be taken together that are 2. $(2\pi/12) = \pi/3$ rad apart, like for example those with phases 0, $\pi/3$ and $2\pi/3$ rad together or those with phases $\pi/6$, $\pi/2$ and $5\pi/6$ rad. The combination of these LO signals can then be fed into the harmonic mixer.

The invention also relates to a device for frequency conversion from RF to IF (or vice versa), comprising a LO running at a subharmonic of the amount of frequency translation (= $F_{RF}-F_{IF}$) with $F_{IF} \neq 0$ (as opposed to what was previously discussed). The device further comprises means for generating signals derived from this local oscillator signal, spaced $\pi/2N$ rad apart, N being an integer. The output signal (e.g. IF) is generated by mixing the input signal (e.g. RF) with said LO signals, spaced $\pi/2N$ rad apart. By further adding a second mixer with the other LO signals, one obtains a full image-reject mixer.

Some of the above-mentioned parameters can be rendered programmable, like e.g. the number of signals to be generated, the integer value N indicating at which subharmonic frequency the local oscillator runs etc. Also the means for combining signals (e.g. the logic circuit) may be reconfigurable. Such small changes may have a considerable impact on the front end's functionality.

The solution of the invention offers several advantages:

- The pulling problem is completely solved, as the VCO is running at half of the RF frequency.
- Instead of routing 4 quadrature LO signals from the synthesiser to the RX and TX sections, now only 2 half frequency signals must be distributed across the chip. The LO-generating DLL can be placed twice, once close to the RX mixer and once close to the TX mixer. For area efficiency, the two loops can possibly share their low-frequency part.
- The above routing advantage also results in a reduction of the power consumption in the LO buffers.
- It allows to implement a frequency conversion device that is to a certain extent programmable.

## Claims

1. Device comprising

   - a device for actively generating a plurality of signals (10) at a first frequency, said first frequency being a subharmonic frequency of a second frequency, said signals (10) being spaced $\pi/X$ rad apart in phase, X being an integer, said device comprising at least one voltage-controlled delay cell (15) with a delay approximately corresponding to a phase shift of $\pi/X$ rad and at least one phase detection system (16) arranged for inputting said at least two signals (10) delayed in phase by $\pi/2$ rad with respect to one another by said at least one voltage-controlled delay cell (15), said at least one phase detection system (16) further being arranged for generating a feedback signal (18) to at least one of said at least one voltage-controlled delay cell (15),

   **characterised in that** it further comprises

   - first means (12) for combining at least two signals (10) from said plurality of signals, yielding a first signal set containing at least one signal at said second frequency.

2. Device as in claim 1, wherein the combination of said at least one voltage-controlled delay cell (15) and said phase detection system (16) is arranged for providing said $\pi/X$ rad phase spacing of said signals (10).

3. Device as in claim 1, wherein said phase detection system (16) is a mixer.

4. Device as in claim 1, further comprising a low pass filter (17) for filtering said feedback signal (18).

**5.** Device as in claim 4, wherein said feedback signal (18) is fed to all voltage-controlled delay cells (15).

**6.** Device as in any of the previous claims, **characterised in that** said at least two signals (10) to be combined by said first means (12) for combining are spaced in phase 2π/X rad apart and **in that** said second frequency is X/2 times larger than said first frequency.

**7.** Device as in claim 6, **characterised in that** X equals 4.

**8.** Device as in claim 6, **characterised in that** it further comprises a second means for combining at least two further signals (10) from said plurality of signals, said at least two further signals being different from the signals (10) applied to said first means, yielding a second signal set containing at least one signal at said second frequency.

**9.** Device as in claim 8, **characterised in that** said at least two signals (10) to be combined by said second means for combining are spaced in phase 2π/X rad apart and **in that** for each of said at least two signals to be combined by said second means for combining there is a signal among said at least two signals to be combined by said first means for combining, that differs π/X rad in phase.

**10.** Device as in claim 9, **characterised in that** X equals 4.

**11.** Device as in any of the previous claims, wherein said means for combining signals includes a logic circuit.

**12.** Device as in any of the previous claims, wherein said means for combining signals includes a combination of switches.

**13.** A device as in claim 9 or 10, whereby said first means for combining is arranged for generating an in-phase signal and said second means for combining is arranged for generating a quadrature output signal.

**14.** A front-end circuit for a transceiver device, comprising a device as in claim 13 and a mixer (21) to which said at least one output signal and transmitted or received signal are fed.

**15.** A zero or low-IF front-end circuit for a transceiver, comprising a device as in claim 13 and a mixer (21) to which said output signals and a transmitted or received signal are fed.

**16.** A device for frequency multiplication comprising a local oscillator arranged for running at a subharmonic frequency of a transmitted or received signal and for generating at least one output signal, said local oscillator comprising a device as in any of claims 1 to 5, whereby signals (10) spaced π/X rad apart in phase are generated X being equal to 2N, N being an integer, and whereby said combined signals generate said at least one output signal and whereby said local oscillator is arranged for running at the N-th subharmonic frequency.

**17.** A device for frequency multiplication as in claim 16, wherein said means for actively generating signals are arranged for exploiting a feedback mechanism for keeping said signals, spaced π/2N rad apart in phase.

**Patentansprüche**

**1.** Gerät umfassend

- ein Gerät zum aktiven Erzeugen mehrerer Signale (10) mit einer ersten Frequenz, wobei die erste Frequenz eine subharmonische Frequenz einer zweiten Frequenz ist, wobei die Signale (10) in der Phase um π/X Rad voneinander getrennt sind, wobei X eine ganze Zahl ist, wobei das Gerät mindestens eine spannungsgesteuerte Verzögerungszelle (15) mit einer Verzögerung, die etwa einer Phasenverschiebung von π/X Rad entspricht, und mindestens ein Phasenerkennungssystem (16), angeordnet zum Eingeben der mindestens zwei Signale (10), die durch die mindestens eine spannungsgesteuerte Verzögerungszelle (15) in Bezug aufeinander in der Phase um π/2 Rad verzögert sind, umfasst, wobei ferner das mindestens eine Phasenerkennungssystem (16) für das Erzeugen eines Rückkopplungssignals (18) an mindestens eine der mindestens einen spannungsgesteuerten Verzögerungszelle (15) angeordnet ist, **dadurch gekennzeichnet, dass** das Gerät ferner umfasst
- ein erstes Mittel (12) zum Kombinieren von mindestens zwei Signalen (10) aus den mehreren Signalen, was einen ersten Signalsatz ergibt, welcher mindestens ein Signal mit der zweiten Frequenz enthält.

**2.** Gerät nach Anspruch 1, wobei die Kombination der mindestens einen spannungsgesteuerten Verzögerungszelle (15) und des Phasenerkennungssystems (16) zum Bereitstellen des π/X Rad Phasenabstandes der Signale (10) angeordnet ist.

**3.** Gerät nach Anspruch 1, wobei das Phasenerkennungssystem (16) ein Mischgerät ist.

**4.** Gerät nach Anspruch 1, ferner umfassend einen Tiefpassfilter (17) zum Filtern des Rückkopplungssignals (18).

**5.** Gerät nach Anspruch 4, wobei das Rückkopplungssignal (18) an alle spannungsgesteuerten Verzögerungszellen (15) geleitet wird.

**6.** Gerät nach einem der vorhergehenden Ansprüche, **dadurch gekennzeichnet, dass** die mindestens zwei Signale (10), die durch das erste Mittel (12) zum Kombinieren kombiniert werden sollen, in der Phase um 2π/X Rad voneinander getrennt sind und **dadurch**, dass die zweite Frequenz X/2 Mal höher ist als die erste Frequenz.

**7.** Gerät nach Anspruch 6, **dadurch gekennzeichnet, dass** X gleich 4 ist.

**8.** Gerät nach Anspruch 6, **dadurch gekennzeichnet, dass** es ferner ein zweites Mittel zum Kombinieren von mindestens zwei weiteren Signalen (10) aus den mehreren Signalen umfasst, wobei sich die mindestens zwei weiteren Signale von den Signalen (10) angewandt auf das erste Mittel unterscheiden, was einen zweiten Signalsatz ergibt, welcher mindestens ein Signal mit der zweiten Frequenz enthält.

**9.** Gerät nach Anspruch 8, **dadurch gekennzeichnet, dass** die mindestens zwei Signale (10), die durch das zweite Mittel zum Kombinieren kombiniert werden sollen, in der Phase um 2π/X Rad voneinander getrennt sind und **dadurch**, dass es für jedes der mindestens zwei Signale, die durch das zweite Mittel zum Kombinieren kombiniert werden sollen, ein Signal unter den mindestens zwei Signalen, die durch das erste Mittel zum Kombinieren kombiniert werden sollen, gibt, welches sich um π/X Rad in der Phase unterscheidet.

**10.** Gerät nach Anspruch 9, **dadurch gekennzeichnet, dass** X gleich 4 ist.

**11.** Gerät nach einem der vorhergehenden Ansprüche, wobei das Mittel zum Kombinieren von Signalen eine Logikschaltung beinhaltet.

**12.** Gerät nach einem der vorhergehenden Ansprüche, wobei das Mittel zum Kombinieren von Signalen eine Kombination von Schaltern beinhaltet.

**13.** Gerät nach Anspruch 9 oder 10, wobei das erste Mittel zum Kombinieren zum Erzeugen eines phasengleichen Signals angeordnet ist und das zweite Mittel zum Kombinieren zum Erzeugen eines Quadraturausgangssignals angeordnet ist.

**14.** Eingangskreis für ein Sendeempfängergerät, umfassend ein Gerät nach Anspruch 13 und ein Mischgerät (21), an welchen das mindestens eine Ausgangssignal und ein gesendetes oder empfangenes Signal geleitet werden.

**15.** Null- oder Niedrig-ZF-Eingangskreis für einen Sendeempfänger, umfassend ein Gerät nach Anspruch 13 und ein Mischgerät (21), an welchen die Ausgangssignale und ein gesendetes oder empfangenes Signal geleitet werden.

**16.** Gerät zur Frequenzmultiplikation, umfassend einen lokalen Oszillator angeordnet zum Laufen mit einer subharmonischen Frequenz eines gesendeten oder empfangenen Signals und zum Erzeugen von mindestens einem Ausgangssignal, wobei der lokale Oszillator ein Gerät wie nach einem der Ansprüche 1 bis 5 umfasst, wobei Signale (10), die in der Phase um π/X Rad voneinander getrennt sind, erzeugt werden, wobei X gleich 2N ist, wobei N eine ganze Zahl ist, und wobei die kombinierten Signale das mindestens eine Ausgangssignal erzeugen, und wobei der lokale Oszillator zum Laufen mit der N-ten subharmonischen Frequenz angeordnet ist.

**17.** Gerät zur Frequenzmultiplikation nach Anspruch 16, wobei die Mittel zum aktiven Erzeugen von Signalen zum Ausnutzen eines Rückkopplungsmechanismus zum Erhalten der Signale, die in der Phase um π/2N Rad voneinander getrennt sind, angeordnet sind.

**Revendications**

1. Dispositif comprenant

   - un dispositif pour générer activement une pluralité de signaux (10) à une première fréquence, ladite première fréquence étant une fréquence sous-harmonique d'une deuxième fréquence, lesdits signaux (10) étant espacés de π/X rad en phase, X étant un nombre entier, ledit dispositif comprenant au moins une cellule de retard commandée en tension (15) avec un retard correspondant approximativement à un déphasage de π/X rad et au moins un système de détection de phase (16) agencé pour entrer lesdits au moins deux signaux (10) retardés en phase de π/2 rad l'un par rapport à l'autre par ladite au moins une cellule de retard commandée en tension (15), ledit au moins un système de détection de phase (16) étant en outre agencé pour générer un signal de rétroaction (18) vers au moins l'une de ladite au moins une cellule de retard commandée en tension (15),

   **caractérisé en ce qu'**il comprend en outre

   - des premiers moyens (12) pour combiner au moins deux signaux (10) parmi ladite pluralité de signaux, produisant un premier ensemble de signaux contenant au moins un signal à ladite deuxième fréquence.

2. Dispositif selon la revendication 1, dans lequel la combinaison de ladite au moins une cellule de retard commandée en tension (15) et dudit système de détection de phase (16) est agencée pour fournir ledit espacement de phase de π/X rad desdits signaux (10).

3. Dispositif selon la revendication 1, dans lequel ledit système de détection de phase (16) est un mélangeur.

4. Dispositif selon la revendication 1, comprenant en outre un filtre passe-bas (17) pour filtrer ledit signal de rétroaction (18).

5. Dispositif selon la revendication 4, dans lequel ledit signal de rétroaction (18) est amené à toutes les cellules de retard commandées en tension (15).

6. Dispositif selon l'une quelconque des revendications précédentes, **caractérisé en ce que** lesdits au moins deux signaux (10) à combiner par lesdits premiers moyens (12) de combinaison sont espacés en phase de 2π/X rad et **en ce que** ladite deuxième fréquence est X/2 fois plus grande que ladite première fréquence.

7. Dispositif selon la revendication 6, **caractérisé en ce que** X est égal à 4.

8. Dispositif selon la revendication 6, **caractérisé en ce qu'**il comprend en outre des deuxièmes moyens pour combiner au moins deux autres signaux (10) parmi ladite pluralité de signaux, lesdits au moins deux autres signaux étant différents des signaux (10) appliqués auxdits premiers moyens, produisant un deuxième ensemble de signaux contenant au moins un signal à ladite deuxième fréquence.

9. Dispositif selon la revendication 8, **caractérisé en ce que** lesdits au moins deux signaux (10) à combiner par lesdits deuxièmes moyens de combinaison sont espacés en phase de 2π/X rad et **en ce que** pour chacun desdits au moins deux signaux à combiner par lesdits deuxièmes moyens de combinaison, il existe un signal parmi lesdits au moins deux signaux à combiner par lesdits premiers moyens de combinaison, qui diffère de π/X rad en phase.

10. Dispositif selon la revendication 9, **caractérisé en ce que** X est égal à 4.

11. Dispositif selon l'une quelconque des revendications précédentes, dans lequel lesdits moyens pour combiner des signaux comprennent un circuit logique.

12. Dispositif selon l'une quelconque des revendications précédentes, dans lequel lesdits moyens pour combiner des signaux comprennent une combinaison de commutateurs.

13. Dispositif selon la revendication 9 ou 10, par lequel lesdits premiers moyens de combinaison sont agencés pour générer un signal en phase et lesdits deuxièmes moyens de combinaison sont agencés pour générer un signal de sortie en quadrature.

**14.** Circuit frontal pour un dispositif émetteur/récepteur, comprenant un dispositif selon la revendication 13 et un mélangeur (21) auxquels ledit au moins un signal de sortie et un signal émis ou reçu sont amenés.

**15.** Circuit frontal à FI nulle ou faible pour un émetteur/récepteur, comprenant un dispositif selon la revendication 13 et un mélangeur (21) auxquels lesdits signaux de sortie et un signal émis ou reçu sont amenés.

**16.** Dispositif de multiplication de fréquences, comprenant un oscillateur local agencé pour fonctionner à une fréquence sous-harmonique d'un signal émis ou reçu et pour générer au moins un signal de sortie, ledit oscillateur local comprenant un dispositif selon l'une quelconque des revendications 1 à 5, par lequel des signaux (10) espacés de $\pi/X$ rad en phase sont générés, X étant égal à 2N, N étant un nombre entier, et par lequel lesdits signaux combinés génèrent ledit au moins un signal de sortie, et par lequel ledit oscillateur local est agencé pour fonctionner à la N-ème fréquence sous-harmonique.

**17.** Dispositif de multiplication de fréquences selon la revendication 16, dans lequel lesdits moyens pour générer activement des signaux sont agencés pour exploiter un mécanisme de rétroaction afin de conserver lesdits signaux, espacés de $\pi/2N$ rad en phase.

Prior art

**Fig.1**

Prior art

**Fig.2**

**Fig.3**

**Fig.4**

**Fig.5**

**2**

LO0

1

2

3

4

5

6

LO7

(0&2)+(4&6)

(1&3)+(5&7)

(0&6)+(2&4)

(1&7)+(3&5)

<u>Fig.6</u>

LO :    4   0          5   1          6   2          7   3

VCOp

VCOn

RF   LO

**16**

RF   LO

**16**

**17**

**18**

<u>Fig.7</u>

12

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5285120 A
- US 5180994 A

- US 20020039052 A1

**Non-patent literature cited in the description**

- An I/Q Active Balanced Harmonic Mixer with IM2 Cancelers and a 45° phase Shifter. *IEEE Journal of Solid-State Circuits,* 12 December 1998, vol. 33, 2240-2246